Europäisches Patentamt

European Patent Office

Office européen des brevets

(11) Publication number: **0 423 648 A1**

# EUROPEAN PATENT APPLICATION

(21) Application number: 90119622.0

(22) Date of filing: 12.10.90

(51) Int. Cl.⁵: **H01L 21/302**

(30) Priority: 20.10.89 JP 273945/89

(43) Date of publication of application:
24.04.91 Bulletin 91/17

(84) Designated Contracting States:
DE FR GB

(71) Applicant: FUJITSU LIMITED
1015, Kamikodanaka Nakahara-ku
Kawasaki-shi Kanagawa 211(JP)

(72) Inventor: Takamatsu, Tsukasa, c/o Fujitsu Ltd.
Patent Department, 1015 Kamikodanaka
Nakahara-ku, Kawasaki-shi, Kanagawa
211(JP)

(74) Representative: Sunderland, James Harry et al
HASELTINE LAKE & CO Hazlitt House 28
Southampton Buildings Chancery Lane
London WC2A 1AT(GB)

(54) Wafer processing.

(57) A wafer processing method comprising the steps
of:-
attaching a glue-carrying flexible protection film over
a surface of said wafer, by the glue, to protect the
surface of the wafer;
baking said protection film attached to the wafer, to
provide for easy peel-off of said protection film with
the glue from the wafer; and
mechanically peeling off said glue-carrying protection film from said wafer.

EP 0 423 648 A1

## WAFER PROCESSING.

The present invention relates to wafer processing and is concerned with the use of a surface protection film, for example a tape in wafer processing, for example when polishing of the rear surface of the wafer takes place in final wafer processing.

In recent years, as semiconductors tend towards increasing microminiaturisation and the use of multilayer structures has become more common, large level differences may be manifest between scribe lines on a wafer and uppermost layer parts formed on the wafer surface.

For protecting a device formed on a wafer when the rear surface of the wafer is to be polished, a method has been used in which the wafer surface is coated with resist. With this method, since the resist covers the wafer surface in a liquid condition and then hardens, the wafer surface can be protected regardless of any level differences which occur at the wafer surface.

However, with this method a problem arises in that it is later difficult to perfectly peel off the resist with a solvent, and microcracks are generated at the surface of a device. This problem becomes more significant as wafer diameter increases.

Accordingly, a tape attaching method has been employed in place of the resist coating method. This tape attaching method has almost solved the problem of microcracks generated at the device surface and is currently the main stream method used for device protection during wafer polishing.

The same object of device protection may be attained generally by use of a protection sheet, as well as a tape, but here explanation of conventional methods will be limited to device protection by tape.

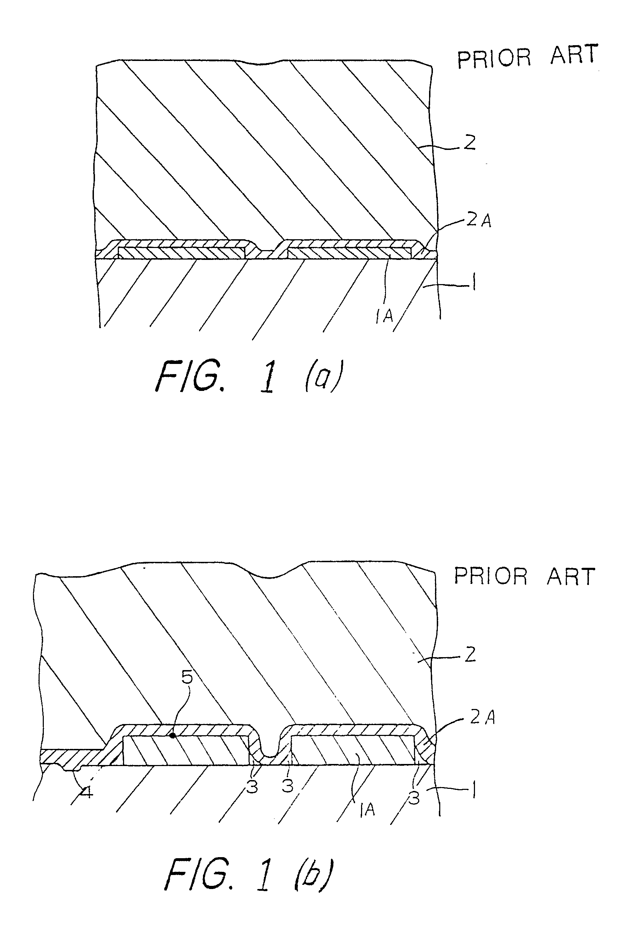

Figs. 1(a) and 1(b) are diagrams for assistance in explaining conventional tape attachment.

Fig. 1(a) shows the attachment of tape to a wafer 1 where the level difference at the surface, namely the level difference between the surface of wafer 1 and the surface of a device 1A formed on the wafer is comparatively small. When a tape is attached to the surface of the wafer 1, even if the thickness of glue 2A is as little as about 5 $\mu$m, for example, the glue perfectly covers the level difference and a large stress is not applied on the device 1A.

Fig. 1(b) shows the attachment of tape to a wafer having a level difference at the surface for example as large as about 3 $\mu$m. In this case, when the tape 2 is attached to the surface of wafer 1, if the glue 2A is applied with a thickness of as little as about 5 $\mu$m, the level difference at the wafer surface is not perfectly covered, resulting in the existence of clearances 3. Therefore, when chemical etching is carried out after polishing the rear surface of wafer 1, etchant such as acid can enter these clearances 3.

If the level difference between a scribe line 4 and an uppermost layer 5 formed on the wafer surface is large, and if tape is attached as a protection film over the wafer surface and chemical etching is then carried out after polishing of rear surface, the etchant (acid) can enter through a clearance between the tape and a scribe line or between the tape and a device at the wafer surface from the side surface of wafer, to destroy the device. This is a problem to which a solution is much desired.

With the tape attaching type protection method, a further, more serious problem is that foreign objects, mainly formed by glue residue, remain at the surface of the wafer from which the tape is peeled off. If such residues adhere in the vicinity of a device on the wafer, various device failures can be generated. Particularly, such residues can result in serious adverse effects such as interference with irradiation by UV rays for a device such as an EP-ROM (erasable and programmable read only memory) in which memory information is erased by using UV rays. Such effects become more significant as the device is more microminiaturised.

This is a problem to which a solution is greatly desired.

According to the present invention, there is provided a wafer processing method comprising the steps of:-

attaching a glue-carrying flexible protection film over a surface of said wafer, by the glue, to protect the surface of the wafer;

baking said protection film attached to the wafer, to provide for easy peel-off of said protection film with the glue from the wafer; and

mechanically peeling off said glue-carrying protection film from said wafer.

An embodiment of the present invention can provide for substantial elimination, or significant reduction, of foreign objects, mainly consisting of glue residues, remaining at a wafer surface after peeling off the protection film (tape or sheet) when a film (tape or sheet) attachment-type protection method is used in wafer processing, for example in the process for polishing the rear surface of the wafer.

An embodiment of the present invention can provide that entrance of acid is prevented or substantially prevented by the protection film (tape or sheet) in a protection film (tape or sheet) attachment-type protection method used in the process for polishing the rear surface of a wafer.

In an embodiment of the present invention, a tape is attached to the surface of the wafer with a glue which is mainly formed by butyl carbitor (or butyl carbitol) and which remains in the solid condition under normal temperature and exhibits fluidity when a pressure is applied thereon. The thickness of such glue is larger than level differences expected at the wafer surface where a device is formed. The tape having such glue is attached on the surface where a device is formed and the rear surface of wafer is polished. Thereafter, the wafer is baked at a temperature from 70°C to 85°C wherein the glue is not coagulated. The rear surface of the silicon wafer having completed the baking is chemically etched to recover strain on the wafer generated during the polishing and make smooth the rear surface of the wafer.

Thereafter, the tape is peeled off from the silicon wafer and foreign objects left on the silicon surface such as residues of tape or glue are washed off by washing with deionised water.

Evaluation by measurements of the occurrence of foreign objects at the wafer surface, using a particle counter and the purple check has demonstrated that the baking has a distinctive effect in reducing the number of occurrences of foreign matters at the wafer surface, in particular in a combination process involving the baking and washing with deionised water.

Reference is made, by way of example, to the accompanying drawings, in which:-

Fig. 1(a) is a diagram schematically indicating conventional tape attachment in the case of a wafer having a comparatively small level difference at its surface;

Fig. 1(b) is a diagram schematically indicating conventional tape attachment in the case of a wafer having a comparatively large level difference at its surface;

Fig. 2 is a schematic sectional view for assistance in explaining tape attachment in accordance with an embodiment of the present invention;

Fig. 3(a) is a schematic diagram indicating intermolecular bonds of glue when a tape is attached and baking is not carried out;

Fig. 3(b) is a schematic diagram indicating residues of glue remaining on a wafer after the tape of Fig. 3(a) is peeled off;

Fig. 3(c) is a schematic diagram indicating intermolecular bonds of glue when a tape is attached and baking has been carried out;

Fig. 3(d) is a schematic diagram indicating that residues of glue are not left on a wafer after the tape of Fig. 3(c) is peeled off;

Figs. 4(a) to 4(e) are schematic sectional diagrams for assistance in explaining an embodiment of the present invention:-

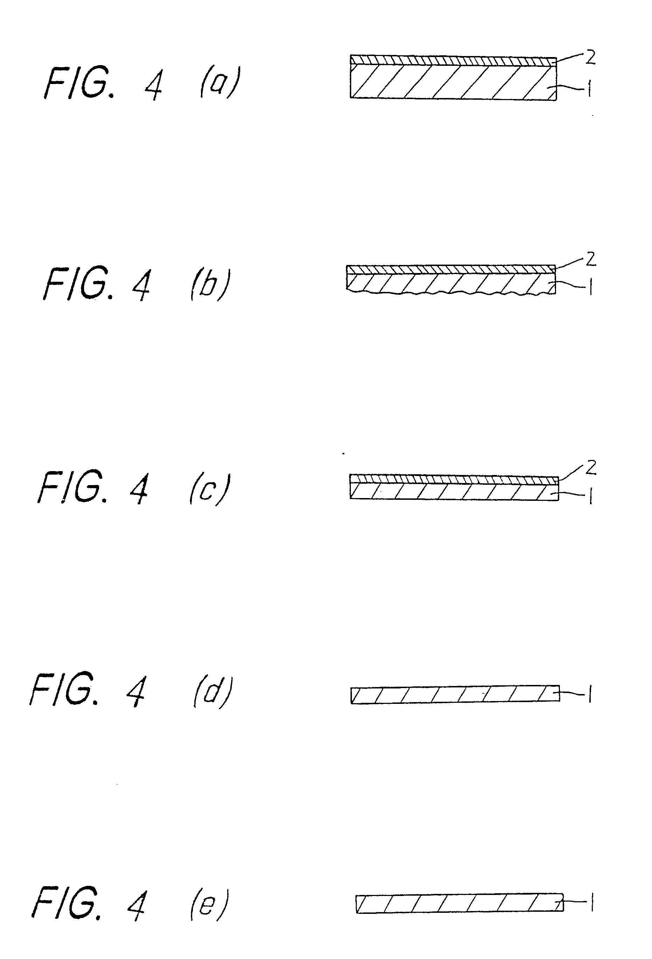

Fig. 4(a) illustrates a step of attachment of tape to the surface of a silicon wafer (device-forming surface);

Fig. 4(b) illustrates a step for setting the silicon wafer to the predetermined thickness by polishing the rear surface of silicon wafer;

Fig. 4(c) illustrates a step for smoothing the rear surface of wafer by conducting chemical etching of the rear surface of silicon wafer as a sample having completed baking;

Fig. 4(d) illustrates a step for peeling off the tape of the sample of Fig. 4(c);

Fig. 4(e) illustrates a step for eliminating remaining residues of tape or glue by washing the silicon wafer of the sample of Fig. 4(d) with deionised water;

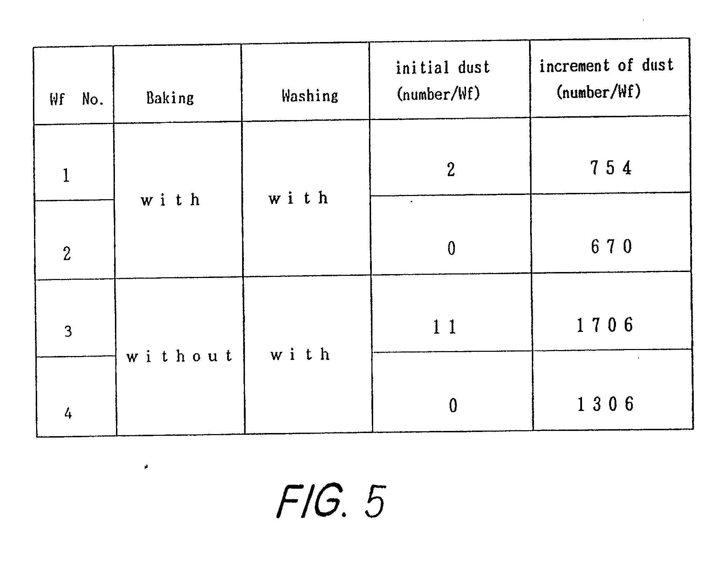

Fig. 5 is a Table giving a comparison of results obtained for cases in which baking is conducted and is not conducted, by evaluating the quantity of foreign matter at wafer surfaces using a particle counter; and

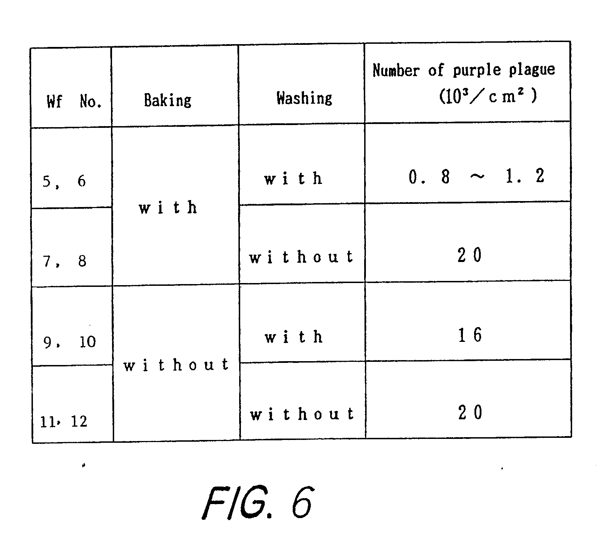

Fig. 6 is a Table giving a comparison of results obtained for cases in which washing with deionised water is conducted and is not conducted, for cases in which baking is conducted and is not conducted, by evaluating the quantity of foreign matter at wafer surfaces using the purple check method.

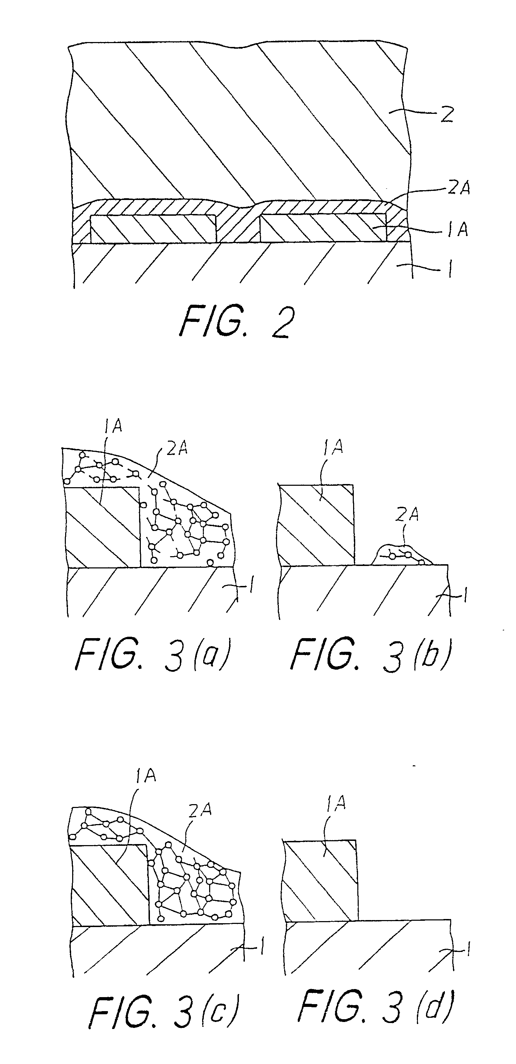

In Figs. 2 to 6 like reference signs designate like elements.

Fig. 2 is a schematic sectional view for assistance in explaining in outline an embodiment of the present invention. As seen in this Figure, when a tape 2 is attached over the surface of a silicon wafer 1, and when glue 2A is thick (about 40 $\mu$m) and soft, the glue is pushed into recessed areas at the surface and perfectly covers projected and recessed areas on the silicon wafer 1 under the condition that a large stress is not applied to a device 1A on the wafer surface.

Such glue is for example mainly composed of butyl carbitor (diethylene glycol monobutyl ether, n-$CH_3(CH_2)_3O(CH_2)_2O(CH_2)_2OH$). This element has a solidifying point of -70°C or less and a coefficient of viscosity of 6.5 cps (20°C). In addition, similar effects can also be obtained by those adding a surface active agent to an aclyric base (an acrylic base).

For instance, thickness of the tape is 160 $\mu$m and adhesive strength for a silicon wafer is 330 g.

The tape is attached to the surface of the silicon wafer and it is then baked. Thereby, the stress generated when the tape is attached on the surface of the silicon wafer and a separate film is peeled off is recovered, enhancing intermolecular bonds of the glue. As a result, generation of residues of glue can be substantially prevented when the tape is peeled off.

Figs. 3(a) to 3(d) are diagrams for assistance in explaining the effect of baking carried out after the tape is attached to the wafer.

Fig. 3(a) is a schematic diagram indicating the intermolecular bonds in glue when the tape is attached to a wafer, when baking has not been effected. As will be seen in the Figure, the intermolecular bonds are broken in some places due to pressure applied when the tape is attached.

Fig. 3(b) illustrates that residues of glue remain even after the tape has been peeled off, in a case in which baking has not been carried out. In this case, since the intermolecular bonds of the glue are weak after the tape is attached, glue residues can easily remain after the tape is peeled off.

Fig. 3(c) is a schematic diagram indicating the intermolecular bonds in glue when the tape is attached and baking has been effected. In this case, the intermolecular bonds of the glue when the tape is attached are (more) perfect and bonds are not broken.

Fig. 3(d) illustrates that residues of glue do not exist after the tape is peeled off, in a case in which the baking of Fig. 3(c) has been effected. When the baking is effected, molecules are activated by the baking and intermolecular bonds become strong and therefore when the tape is to be peeled off, the glue is removed by the tape and substantially no glue residues are left on the silicon wafer.

The baking may, for example, be conducted for one minute or longer to about 80°C using a hotplate, or for about 5 minutes at about 80°C within an annealing furnace. The baking temperature is determined in dependence upon the thermal resistance of the tape. Generally, for example, the tape may be formed by a copolymer of vinyl chloride or vinyl acetate with a melting point set to 60°C to 90°C. The baking temperature should preferably be lower than the solidifying point of the glue.

Next, an actually conducted tape attaching method in accordance with an embodiment of the present invention will be explained with reference to schematic diagrams indicating respective steps.

Fig. 4(a) indicates a step for attaching a tape 2 on the surface (device-forming surface) of a silicon wafer 1 (devices on the wafer surface are not illustrated in Fig. 4(a). The material of the tape used is a copolymer of vinyl group and is formed with a thickness of about 160 $\mu$m. Moreover, a coating of glue has, as explained above, a thickness of about 40 $\mu$m and is mainly composed of butyl carbitor (butyl carbitol).

Fig. 4(b) indicates a step for polishing the rear surface of the silicon wafer 1 to achieve a selected thickness (for example, the initial thickness of about 620 $\mu$m is reduced to about 400 $\mu$m). The polishing process is similar to mechanical polishing which is usually conducted in the silicon wafer process.

Thereafter, the sample (wafer with tape) is baked on an ordinary hotplate (the baking process is not illustrated). The baking is carried out under atmospheric conditions and the baking temperature generally depends on the mother material of the tape and also on the peeling properties of the glue.

In a case in which a mother material of the vinyl group is used, the baking temperature may range from 50°C to 150°C for example, and desirably from 70°C to 90°C. Below 50°C, the effect of baking is small, but otherwise quality change of the tape is remarkable below 150°C.

Fig. 4(c) indicates a step for recovering strain on the wafer, generated during the polishing process, and smoothing the rear surface of wafer by effecting chemical etching of the rear surface of silicon wafer of the sample after baking. In the chemical etching, etching of about 7 $\mu$m is realised with a mixed acid of fluoric acid and nitric acid.

Fig. 4(d) indicates a step for peeling off the tape 2 from the sample of Fig. 4(c).

Fig. 4(e) indicates a step for removing residues of tape and glue by washing the silicon wafer 1 of the sample of Fig. 4(d) with deionised water.

Fig. 5 and Fig. 6 are Tables provided to indicate the effects of baking processes as provided in embodiments of the present invention.

Fig. 5 gives the results of evaluation of quantity of foreign matter such as residues, on the surfaces of 6-inch silicon wafers manufactured by the manufacturing processes of Figs. 4(a) to 4(e) and gives comparative results for wafers for which baking is not conducted.

First, the number of occurrences of foreign matter on the surfaces of four kinds of wafer (Wf No. 1, 2, 3, 4) are measured in advance. These values are described in the fourth column (initial dust) of Fig. 5.

Tape was then attached to these wafers. Those samples (wafers and tape) which were baked were held at 70°C on a hotplate and baked for two minutes.

Thereafter, the samples were left for 12 hours at room temperature.

The tape was then peeled off and the samples were washed for 15 minutes using deionised water and then dried.

The number of occurrences of foreign matter at the wafer surfaces was then measured again. These values are probably increased from the initial values and the increments are respectively described in the fifth column (increment of dust) of Fig. 5.

A particle counter (TOPCON WM-3, available in the market) was used for measuring the number of occurrences of foreign matter on the surfaces of the wafers. The size of foreign matter measured was 0.2 $\mu$m or larger and regions within 10 mm from wafer edges were excepted from the range of measurement for all cases, in order to conduct accurate measurement.

As will be understood from Fig. 5, the increment in number of occurrences of foreign matter found on the wafer surface after the tape is peeled is reduced to about half in cases in which baking is conducted in comparison with cases in which baking is not conducted.

In measurement of foreign matter on a wafer surface using a particle counter, scattering of light is used and therefore a film, for example, as thin as 10 nm which is smaller than the wavelength of light, adhered on the surface cannot be measured. Therefore, the baking effect can be evaluated more accurately (i.e. for thinner foreign matter) by effecting measurement by the well-known purple check. Therefore, the purple check was carried out for wafer samples, with and without baking and with and without washing, in the sequence explained hereunder. First, aluminium (A$\ell$) was evaporated on the surface of the measuring samples to a thickness of about 1 $\mu$m. Tape was then attached on the surfaces.

For wafer samples which were baked, the samples were held at 70° C on a hotplate for baking for two minutes. Thereafter, the samples were left at room temperature for 12 hours.

Tape was then peeled off the samples.

For wafer samples which were washed, washing by deionised water for 15 minutes was effected and then the samples dried.

Thereafter, gold (Au) was evaporated on the samples. Next, annealing was carried out for 10 minutes at 450° C under the nitrogen ambience. As a result, a "purple plague" generated on the surface can be measured with a microscope.

Fig. 6 is a Table for comparison of results achieved when washing with deionised water was conducted or was not conducted, for cases in which baking was conducted and was not conducted. The results were obtained by evaluating quantity of foreign matter (such as residues) on the surfaces of eight samples. The fourth column of the Table describes mean values of purple plague in each case for two wafers. According to this result, when the baking and washing by deionised water are conducted, the mean value of purple plague is minimized but when the baking is not conducted, the mean value thereof is about 15 to 25 times higher. However, if the washing by deionised water is not conducted even when the baking is conducted, the mean value of purple plague can also reach about 20 times. Namely, a process combining baking and washing by deionised water results in a particularly distinctive effect for removing foreign matter such as residues at the surface of a wafer.

An embodiment of the present invention provides a method of reducing dust (for example, glue residues) remaining on a wafer surface after tape has been peeled off in the following process:- attaching an adhesive tape to the surface of a silicon substrate forming devices, polishing the other surface of silicon substrate to the predetermined thickness, baking the substrate for several minutes at about 80° C, chemically etching the polished surface and washing the surface of silicon substrate by deionised water after the tape is peeled off.

An embodiment of the present invention provides a wafer processing method by protection of a wafer surface with a protection film, said method comprising the steps of:-
attaching a flexible protection film by glue thereof over the surface of said wafer;
baking said protection film attached wafer to easily peel off said protection film from the wafer; and
mechanically peeling off said protection film and glue from said wafer.

An embodiment of the present invention provides a wafer processing method by protection of wafer surface having projected and recessed areas with a protection film, said method comprising the steps of:-
attaching a flexible protection film having a thickness of glue larger than level difference of said projected and recessed area on said wafer;
baking said protection film attached wafer to easily peel off said protection film from said protection film attached wafer; and
mechanically peeling off said protection film and glue from said wafer.

An embodiment of the present invention provides a wafer processing method through protection of wafer surface with a protection film, said method comprising the steps of:-
forming a semiconductor device on the one surface of said wafer, from which project and recessed area results;
attaching said flexible protection film having a sufficient thickness of glue for filling said projected and recessed areas on said wafer;
baking said protection film attached wafer to easily peel off said protection film from said protection film attached wafer; and
mechanically peeling off said protection film and glue from said wafer.

This method may also comprise the steps of:-
polishing an exposed surface of said protection film attached wafer;
etching the exposed surface of said wafer after said baking step; and
washing the surface of said wafer with a liquid dissolving said glue after said peeling step.

## Claims

1. A wafer processing method comprising the steps of:-

attaching a glue-carrying flexible protection film over a surface of said wafer, by the glue, to protect the surface of the wafer;

baking said protection film attached to the wafer, to provide for easy peel-off of said protection film with the glue from the wafer; and

mechanically peeling off said glue-carrying protection film from said wafer.

2. A wafer processing method as claimed in claim 1, wherein the wafer surface has projected and recessed portions and the thickness of glue on the flexible protection film is larger than level differences of between said projected and recessed portions.

3. A wafer processing method as claimed in claim 2, comprising forming a semiconductor device on the wafer surface of said wafer, from which device said projected and recessed portions result.

4. A wafer processing method as claimed in claim 1, 2 or 3, wherein said baking is effected at a temperature higher than room temperature but lower than a temperature which would result in a substantial change in quality of the mother material of the protection film.

5. A wafer processing method as claimed in claim 1, 2, 3 or 4, wherein said baking is effected at a temperature in the range 50°C to 150°C, for example at a temperature in the range 70°C to 90°C.

6. A wafer processing method as claimed in any preceding claim, wherein the material of the protection film is composed of an organic polymer film and the glue is mainly composed of butyl carbitor.

7. A wafer processing method as claimed in any preceding claim, comprising, after the protection film has been peeled off, washing said wafer surface in a liquid which dissolves the glue.

8. A wafer processing method as claimed in claim 7, wherein the liquid is or contains water, for example deionised water.

9. A wafer processing method as claimed in any preceding claim, comprising, before peeling off the protection film, removing a portion of an exposed surface of the wafer.

10. A wafer processing method as claimed in claim 9, wherein at least chemical etching is employed for removing said portion of the exposed surface of the wafer.

11. A wafer processing method as claimed in claim 9 or 10, comprising polishing said exposed surface of the wafer and etching said exposed surface of the wafer after baking.

12. A wafer processing method as claimed in claim 9, 10 or 11, wherein said wafer comprises silicon and etching of said exposed surface of the wafer is effected with a solution containing fluoric acid and nitric acid.

FIG. 1 (a)

PRIOR ART

FIG. 1 (b)

PRIOR ART

FIG. 2

FIG. 3 (a)

FIG. 3 (b)

FIG. 3 (c)

FIG. 3 (d)

FIG. 4 (a)

FIG. 4 (b)

FIG. 4 (c)

FIG. 4 (d)

FIG. 4 (e)

| Wf No. | Baking | Washing | initial dust (number/Wf) | increment of dust (number/Wf) |
|--------|--------|---------|--------------------------|-------------------------------|
| 1 | with | with | 2 | 7 5 4 |
| 2 | | | 0 | 6 7 0 |
| 3 | without | with | 1 1 | 1 7 0 6 |
| 4 | | | 0 | 1 3 0 6 |

*FIG. 5*

EP 0 423 648 A1

| Wf No. | Baking | Washing | Number of purple plague ($10^3$ / c m$^2$ ) |
|--------|--------|---------|-----------------------------------------|
| 5, 6 | with | with | 0. 8 ～ 1. 2 |
| 7, 8 | | without | 2 0 |
| 9, 10 | without | with | 1 6 |
| 11, 12 | | without | 2 0 |

*FIG. 6*

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| X | EP-A-0 146 197 (STAUFFER CHEM. CO.)<br>* Page 2, line 23 - page 6, line 16 *<br>— — — | 1,4,5 | H 01<br>L 21/302 |
| A | DE-A-3 040 675 (PHILIPS)<br>* Page 5, lines 5-35 *<br>— — — | 1,6,7,<br>10-12 | |
| A | EP-A-0 260 994 (JAPAN SYNTHETIC RUBBER CO.)<br>* Claim 1 *<br>— — — | 1,9-11 | |
| A | PATENT ABSTRACTS OF JAPAN, vol. 6, no. 119<br>(E-116)[997], 3rd July 1982;<br>& JP-A-57 045 929 (NIPPON DENKI K.K.) 16-03-1982<br>* Abstract; figures *<br>— — — | 1,9,11 | |
| A | PATENT ABSTRACTS OF JAPAN, vol. 10, no. 69<br>(E-389)[2126], 18th March 1986;<br>& JP-A-60 219 750 (FUJITSU K.K.) 02-11-1985<br>* Abstract; figures *<br>— — — — — | 1,6-11 | |

TECHNICAL FIELDS
SEARCHED (Int. Cl.5)

H 01 L

The present search report has been drawn up for all claims

| Place of search | Date of completion of search | Examiner |
|---|---|---|
| The Hague | 23 November 90 | GELEBART J.F.M. |

CATEGORY OF CITED DOCUMENTS

X : particularly relevant if taken alone
Y : particularly relevant if combined with another
document of the same category
A : technological background
O : non-written disclosure
P : intermediate document
T : theory or principle underlying the invention

E : earlier patent document, but published on, or after
the filing date
D : document cited in the application
L : document cited for other reasons

 

&: member of the same patent family, corresponding
document